# EUROPEAN PATENT APPLICATION

(11) **EP 0 614 125 A1**
(43) Date of publication of application: **07.09.1994**
(21) Application number: 94200509.1
(22) Date of filing: 25.02.1994
(51) Int. Cl.: G03F 7/24

(54) **Method and device for preparing flexible photo-sensible printing plates arranged on a cylindrical carrier**

(30) Priority: 25.02.1993 NL 9300357
(71) Applicant: ANDERSON & VREELAND B.V., NL-2408 AW Alphen a/d Rijn (NL)
(72) Inventor: Van Der Horst, Hans, NL-2465 AR Rijnsaterwoude (NL)
(74) Representative: Eveleens Maarse, Pieter

(57) **Abstract**

The invention relates to a method for preparing flexible photo-sensible printing plates arranged on a cylindrical carrier, comprising exposing, developing and attaching the flexible photo-sensible printing plates on the cylindrical carrier, wherein the flexible photo-sensible printing plates are initially attached onto the cylindrical carrier, and the flexible photo-sensible printing plates are exposed in the situation arranged on the cylinder and then developed.

In preference a transparency provided with a pattern is arranged in register on the flexible photo-sensible printing plates and the flexible photo-sensible printing plate is then exposed through the transparency.

The invention likewise relates to a device for preparing a printing plate attached onto a cylindrical carrier, comprising a mandrel for fixing the cylindrical carrier and an exposure member for exposing the flexible photo-sensible printing plate attached onto the cylindrical carrier.

## Description

The present invention relates to a method for preparing flexible photo-sensible printing plates arranged on a cylindrical carrier fit for printing, comprising exposing, developing and attaching the flexible photo-sensible printing plates on the cylindrical carrier.

Such a method is generally known.

In this known method, starting from an unexposed printing plate, the flexible photo-sensible printing plate is initially exposed and developed. It is then washed and dried. Prior to the start of the printing process the printing plate thus prepared for flexible printing or rotation relief printing must be attached onto a so-called format cylinder, or attached onto a so-called sleeve, whereafter the sleeve with the printing plate etc. must be fixed on the format cylinder.

The fixing of the flexible printing plate on this cylindrical carrier must take place in register in order to allow the printing plate to print in register. This is a laborious process requiring complicated machines and great skill, and is moreover time-consuming.

The object of the present invention is to provide a method wherein the above stated drawbacks are avoided.

This object is achieved in that the flexible photo-sensible printing plates are initially attached onto the cylindrical carrier, and the flexible photo-sensible printing plates are exposed in the situation arranged on the cylinder and then developed.

The printing plate attached to the cylinder or sleeve thus fit for printing is thus in register and it can be applied onto the printing cylinder without time consuming handling and it can be printed.

The invention likewise relates to a device for preparing a printing plate attached onto a cylindrical carrier fit for printing, comprising a mandrel for fixing the cylindrical carrier and a member for exposing in register the flexible photo-sensible printing plate attached onto the cylindrical carrier.

It is noted that a device and a method for exposing a flexible photo-sensible printing plate attached to a cylindrical carrier are known from DE-A-260382. The method for attaching the printing plate to the carrier is however not permanent; when the cylindrical carrier is removed from the carrier the vacuum will disappear and the printing plate will come loose from the cylindrical carrier. Besides use is made of a transparent foil which does allow exposure of the printing plate, but which does not allow printing.

The invention will be elucidated hereinbelow with reference to the annexed figure, in which is shown a partially broken away schematic perspective view of a device according to the invention.

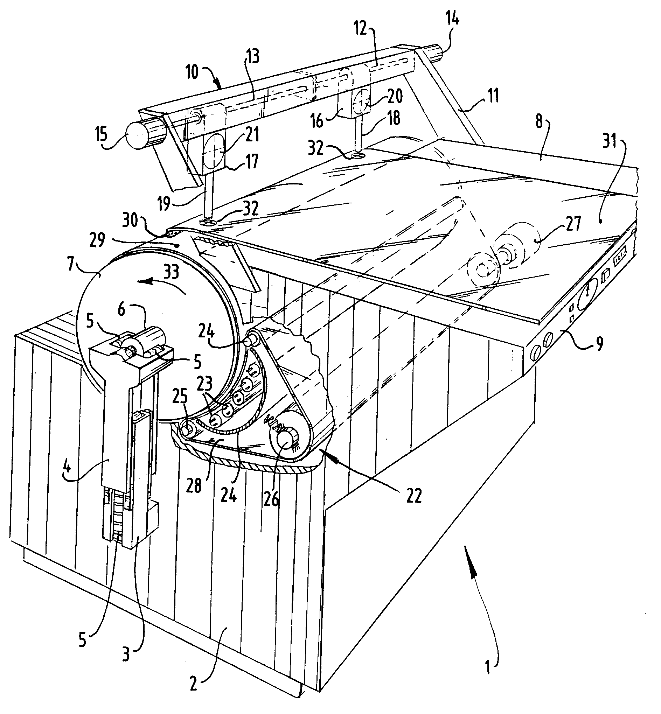

The device 1 depicted in the figure comprises a base body 2 in which is fixed a frame (not shown in the drawing). Two holding brackets 3 protruding outside the base body 2 are fixed to the frame. A cylinder holder 4 is arranged movably in vertical direction on each of the brackets 3. Between the cylinder holder 4 and the bracket 3 is arranged a jack 5 which can be operated by means of an electric motor (not shown in the drawing). The height of the cylinder holder 4 can be adjusted by operating the jack. A corresponding device is arranged on the other side of base body 2. Arranged on the top of cylinder holder 4 is a support roller (not shown in the drawing) in addition to two guide rollers 5.

A shaft end part 6 forming a part of a cylinder-shaped mandrel 7 is placed on the support rollers of each of the cylinder carriers 4.

The device further comprises a positioning table 8 which forms part of base body 2. A control panel 9 is further arranged under the table on the front side of the device.

A camera holder 10 is further arranged above the central shaft of the mandrel 7, that is above the central line of both mandrel supporting devices 5. The camera holder 10 is fixed to the housing 2 by means of two brackets 11. Camera holder 10 further comprises two threaded spindles 12, 13 which are each drivable by means of electric motors 14 respectively 15 connected thereto. Fixed to each of the threaded spindles 12, 13 is a camera 16 respectively 17, which are each provided with a downward extending lens system 18, 19 respectively. It is also possible to move the camera by hand. Arranged on each of the cameras 16, 17 is a reproducing device 20, 21 respectively with which the image observed by the camera is reproduced.

It is otherwise possible to reproduce half of each of the images of both cameras on a single monitor. This can facilitate the positioning.

Finally, an exposure device 22 is arranged in the housing 2. The exposure device 22 is formed by a set of lamps 23 which are suitable for transmitting light, for which the printing plates are sensible. The spectrum thereof could belong to sunlight, but can also at least partially belong to other frequencies. A reflector 24 is arranged on the outside of the lamps 23, while two guide rollers 24, 25 respectively are further arranged connecting onto the periphery of mandrel 7, and a drive roller 26 is arranged behind the reflector. The drive roller is driven by an electric motor 27. An endless band of transparent foil 28 is trained round drive roller 26 and both guide rollers 24, 25.

The endless band 28, and therewith the mandrel 7, are driven by driving the motor 27.

A so-called sleeve 29 is attached to the mandrel 7. This can be attached thereon by stretching, as described in the Netherlands patent application number 9101611. On sleeve 29 is further arranged a flexible photo-sensible printing plate 30, while a transparency 31 provided with a pattern is situated on the table.

The operation of the device will now be described.

The starting point is the situation shown in the figure, with the understanding that no transparency 31 provided with a pattern is present on the positioning table 8, but that a flexible photo-sensible printing plate 30 is placed thereon, and that the flexible photo-sensible printing plate is thus not yet present on the sleeve 29.

The sleeve 29, on the other hand, is arranged on the mandrel 7.

Starting from the described situation, the leading edge of the flexible photo-sensible printing plate situated on positioning table 8 is initially moved onto sleeve 29 and attached thereto, for example by means of glue.

The foil 28 and the mandrel 7 are then rotated further by means of the motor 27, wherein the flexible photo-sensible printing plate is pulled further onto the mandrel 7. The flexible photo-sensible printing plate is herein continuously glued onto the sleeve, for example using resin curing under UV light or adhesive.

This process is continued until the whole flexible photo-sensible printing plate 30 is attached onto the sleeve 29.

A transparency 31 provided with a pattern is then placed on the positioning table 8. The cameras 16, 17 are herein initially placed such that they are centred on the positions of aligning crosses 32 or register marks arranged on the transparent carrier. Use can herein be made of the electric motors 14, 15.

The strip of the transparency 31 attached above the flexible photo-sensible printing plate is subsequently attached to the flexible printing plate, for example by means of a strip of adhesive tape. The mandrel 7 is then driven, again in the direction of the arrow 33, wherein the transparency is pulled further onto the flexible photo-sensible printing plate. This is continued until the transparency is arranged in its entirety on the flexible photo-sensible printing plate.

Thereafter the mandrel 7 can be driven in the direction opposite to arrow direction 33, wherein the assembly of flexible photo-sensible printing plate and transparency provided with a pattern and arranged thereon is carried past the exposure device 22. This is of course switched on before the combination of the carrier and transparency passes by, wherein the foil 28 ensures that the carrier provided with a pattern is pressed firmly against the flexible photo-sensible printing plate without enclosing air, so that during exposure the distance between the pattern and the flexible photo-sensible printing plate is as small as possible to prevent loss of sharp focus.

Further exposure takes place automatically, which implies that the width of the gap through which the light from the light source passes is adjusted automatically in dependance of for instance the diameter of the sleeve.

This process is continued until the whole printing plate has been exposed. The carrier provided with a pattern is then removed and sleeve 29 together with the exposed printing plate arranged thereon is removed from mandrel 7. For this purpose the mandrel is initially lifted out of the carriers 4, whereafter the whole can be removed. The printing plate is then developed, rinsed and finally treated, whereafter it is ready for the printing process.

An advantage of the invention lies in the fact that only the exposure has to take place in register instead of a completed printing plate ore printing plates being attached in register on a sleeve. A transparency is in any case easier to position and place in register than a heavy printing plate, while it is possible to process uncorrected (100 %) negatives. Besides the quality of printing is substantially enhanced as caused by the missing of the so called quetsch rims, forming a common negative artefact.

## Claims

1. Method for preparing flexible photo-sensible printing plates arranged on a cylindrical carrier, comprising exposing, developing and attaching the flexible photo-sensible printing plates on the cylindrical carrier, **characterized in that** the flexible photo-sensible printing plates are initially attached onto the cylindrical carrier, and the flexible photo-sensible printing plates are exposed in register in the situation arranged on the cylinder and then developed.

2. Method as claimed in claim 1, **characterized in that** a transparency provided with a pattern is arranged in register on the flexible photo-sensible printing plates and that the flexible photo-sensible printing plate is then exposed through the transparency.

3. Device for preparing a printing plate attached onto a cylindrical carrier, comprising a mandrel for fixing the cylindrical carrier and an exposure member for exposing the flexible photo-sensible printing plate attached onto the cylindrical carrier.

4. Device as claimed in claim 3, **characterized in that** the exposure member is formed by a light source with an intensity which can be modulated which is movable parallel to the shaft of the mandrel, and wherein the intensity is modulated by information stored in a memory and relating to the image to be printed.

5. Device as claimed in claim 3, **characterized by** means for fixing a carrier comprising a pattern in register on the flexible photo-sensible printing plate.

6. Device as claimed in claim 5, **characterized in that** the means for fixing the carrier comprising a pattern on the flexible photo-sensible printing plate are formed by cameras provided with a sight, wherein the position of the cameras is adjustable using a position reference.

7. Device as claimed in claim 6, **characterized in that** the cameras are placed above the shaft of the mandrel and are movable along the shaft of the mandrel.

8. Device as claimed in any of the claims 5-7, **characterized in that** the exposure member comprises a light source, wherein between the light source and the transparent carrier provided with a pattern means are arranged for pressing the carrier against the flexible photo-sensible printing plate.

9. Device as claimed in claim 8, **characterized in that** the pressing means are formed by an endless transparent band, manufactured for instance from polyester, guided between the carrier and the light source.

10. Device as claimed in claim 9, **characterized in that** the mandrel is drivable in rotation by means of the band and that the mandrel is supported by a supporting device which is adaptable to the diameter of the mandrel.

11. Device as claimed in claims 9 and 10, **characterized in that** the exposure member is adaptable to the diameter of the mandrel.

12. Device as claimed in claim 11, **characterized by** means for automatically adjusting the exposure member to the diameter of the mandrel.
